# EUROPEAN PATENT APPLICATION

(11) **EP 3 471 111 A1**
(43) Date of publication of application: **17.04.2019**
(21) Application number: 17813226.2
(22) Date of filing: 09.06.2017
(51) Int. Cl.: H01B 5/14, B32B 9/00, B32B 15/08, C01G 19/00, C01G 33/00, H01L 51/50, H05B 33/04, H05B 33/12, H05B 33/28

(54) **TRANSPARENT CONDUCTOR**

(30) Priority: 13.06.2016 JP 2016117142
(71) Applicant: TDK Corporation, Tokyo 1036128 (JP)
(72) Inventor: SHINGAI Hiroshi, Tokyo 108-0023 (JP); TAMAGAWA Yoshihisa, Tokyo 108-0023 (JP); TANABE Yoshihiko, Tokyo 108-0023 (JP); SATO Yoshinori, Tokyo 108-0023 (JP)
(74) Representative: Epping - Hermann - Fischer
(86) International application number: PCT/JP2017/021450
(87) International publication number: WO 2017/217329

(57) **Abstract**

A transparent conductor 100 includes: a transparent resin base material 10; a first metal oxide layer 12; a metal layer 16 including a silver alloy; and a second metal oxide layer 14, in this order. The first metal oxide layer 12 contains at least one of tin oxide and niobium oxide. When the tin oxide and the niobium oxide are respectively set in terms of SnO₂ and Nb₂O₅, a molar basis content of the total of SnO₂ and Nb₂O₅ with respect to the total of metal oxides contained in the first metal oxide layer 12 is greater than a molar basis content of the total of SnO₂ and Nb₂O₅ with respect to the total of metal oxides contained in the second metal oxide layer 14, and the content in the first metal oxide layer 12 is greater than or equal to 45 mol%.

## Description

### Technical Field

The present disclosure relates to a transparent conductor.

### Background Art

A transparent conductor has been used as a transparent electrode of a display such as a liquid crystal display (LCD), a plasma display panel (PDP), and an electroluminescence panel (an organic EL and an inorganic EL), a solar battery, and the like. In addition, the transparent conductor has also been used in an electromagnetic wave shielding film, an infrared ray preventing film, and the like. ITO obtained by adding tin (Sn) to indium oxide (In₂O₃), has been widely used as a material of a metal oxide layer in the transparent conductor.

The transparent conductor has been required to be excellent in transparency, and in various properties according to the application. In addition, various materials have been considered, according to the refinement of the patterning, from the viewpoint of a manufacturing process. For example, in Patent Literature 1, a transparent conductive film having a laminated structure of a metal oxide layer containing indium oxide or zinc oxide as a main component, and a metal layer, is proposed.

### Citation List

### Patent Literature

Patent Literature 1: Japanese Unexamined Patent Publication No. 2002-157929

### Summary of Invention

### Technical Problem

A transparent conductor having both of transparency and conductivity, has been used in various applications. For example, in a case where the transparent conductor is used as an electrode of an organic device, in order to ensure reliability of an organic layer, the permeation of moisture is required to be suppressed. In such a transparent conductor, a conductive portion and an insulating portion are formed according to a patterning process. In order to smoothly perform such a patterning process, the transparent conductor is also required to be excellent in etching properties.

Therefore, an object of the present invention is to provide a transparent conductor in which patterning is easily performed, and excellent water vapor barrier properties can be maintained even after the patterning.

### Solution to Problem

In one aspect, the present invention provides a transparent conductor, including: a transparent resin base material, a first metal oxide layer, a metal layer including a silver alloy, and a second metal oxide layer, in this order, in which the first metal oxide layer contains at least one of tin oxide and niobium oxide, and when the tin oxide and the niobium oxide are respectively set in terms of SnO₂ and Nb₂O₅, a molar basis content of the total of SnO₂ and Nb₂O₅ with respect to the total of metal oxides contained in the first metal oxide layer, is greater than a molar basis content of the total of SnO₂ and Nb₂O₅ with respect to the total of metal oxides contained in the second metal oxide layer, and the content in the first metal oxide layer is greater than or equal to 45 mol%.

In the second metal oxide layer of the transparent conductor, the molar basis content of the total of SnO₂ and Nb₂O₅ with respect to the total of the metal oxides, is less than that in the first metal oxide layer, and thus, the second metal oxide layer is more easily dissolved in an etching liquid containing a phosphoric acid, an acetic acid, a nitric acid, and a hydrofluoric acid, than the first metal oxide layer. For this reason, the second metal oxide layer and the metal layer are removed by the etching liquid, and thus, patterning is easily performed.

The first metal oxide layer remaining without being etched, is excellent in water vapor barrier properties. Accordingly, the transparent conductor is capable of maintaining excellent water vapor barrier properties even after the patterning. Therefore, for example, in a case of producing a device in which an organic layer or the like is laminated on the patterned transparent conductor, the infiltration of moisture with respect to the organic layer is suppressed, and thus, the reliability of the device can be improved.

It is preferable that the first metal oxide layer is not dissolved in an etching liquid containing a phosphoric acid, an acetic acid, a nitric acid, and a hydrofluoric acid, in which the second metal oxide layer is dissolved. Accordingly, it is possible to further improve the water vapor barrier properties while easily performing the patterning.

The first metal oxide layer may contain tin oxide, and when the tin oxide is set in terms of SnO₂, a content of SnO₂ with respect to the total of the metal oxides, may be greater than or equal to 30 mol%. According to such a composition, it is possible to make excellent water vapor barrier properties and insolubility with respect to the etching liquid compatible at a higher level. In addition, it is also possible to improve alkali resistance.

The first metal oxide layer may contain niobium oxide, and when the niobium oxide is set in terms of Nb₂O₅, a content of Nb₂O₅ with respect to the total of the metal oxides, may be greater than or equal to 50 mol%. According to such a composition, it is possible to make excellent water vapor barrier properties and the insolubility with respect to the etching liquid compatible at a higher level.

The first metal oxide layer may be amorphous. Accordingly, it is possible to further improve the water vapor barrier properties in the first metal oxide layer.

The first metal oxide layer may contain at least one of tin oxide and niobium oxide, and at least one selected from zinc oxide, indium oxide, and titanium oxide. When five components of the tin oxide, the niobium oxide, the zinc oxide, the indium oxide, and the titanium oxide are respectively set in terms of SnO₂, Nb₂O₅, ZnO, In₂O₃, and TiO₂, the content of the total of SnO₂ and Nb₂O₅ with respect to the total of the five components, for example, is 45 mol% to 80 mol%. The content of the total of ZnO, In₂O₃, and TiO₂ with respect to the total of the five components, for example, is 20 mol% to 55 mol%. According to such a composition, it is possible to improve the alkali resistance, while making excellent water vapor barrier properties and the insolubility with respect to the etching liquid compatible at a higher level.

The second metal oxide layer may contain zinc oxide, indium oxide, titanium oxide, and tin oxide, and when four components of the zinc oxide, the indium oxide, the titanium oxide, and the tin oxide are respectively set in terms of ZnO, In₂O₃, TiO₂, and SnO₂, a content of ZnO may be 20 mol% to 50 mol%, a content of In₂O₃ may be 20 mol% to 35 mol%, a content of TiO₂ may be 10 mol% to 15 mol%, and a content of SnO₂ may be 12 mol% to 30 mol%, with respect to the total of the four components. Accordingly, solubility with respect to the etching liquid is improved, and the patterning is more easily performed.

The silver alloy in the metal layer, may include Ag, Pd, and Cu, as a constituent element. Accordingly, a degradation such as the migration of the metal layer, is further suppressed, and corrosion resistance of the transparent conductor can be improved.

In some embodiments, the transparent conductor may be patterned such that a part of the first metal oxide layer is exposed, and may further include: a first laminated portion including the transparent resin base material and the first metal oxide layer, in which the first metal oxide layer is exposed; and a second laminated portion including the transparent resin base material, the first metal oxide layer, the metal layer, and the second metal oxide layer. Even though the transparent conductor is patterned, the first laminated portion and the second laminated portion include the first metal oxide layer, and thus, the transparent conductor is excellent in the water vapor barrier properties.

### Advantageous Effects of Invention

It is possible to provide a transparent conductor in which patterning is easily performed, and excellent water vapor barrier properties can be maintained even after the patterning.

### Brief Description of Drawings

FIG. 1 is a sectional view of a transparent conductor according to one embodiment.
FIG. 2 is a sectional view of a transparent conductor according to another embodiment.
FIG. 3 is a sectional view of a transparent conductor according to still another embodiment.

### Description of Embodiments

Embodiments of the present invention will be described in detail, with reference to the drawings. However, the following embodiments are an example for describing the present invention, and are not intended to limit the present invention to the following contents. In the description, the same reference numerals will be used in the same constituents or constituents having the same function, and according to a case, the repeated description will be omitted. In addition, unless otherwise noted, a positional relationship such as up, down, right, and left, is based on a positional relationship illustrated in the drawings. Further, a dimensional ratio of the drawings is not limited to the illustrated ratio.

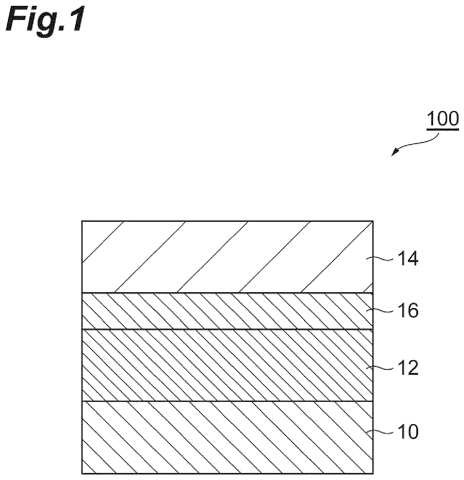

FIG. 1 is a sectional view illustrating one embodiment of a transparent conductor. A transparent conductor 100 has a laminated structure in which a film-like transparent resin base material 10, a first metal oxide layer 12, a metal layer 16, and a second metal oxide layer 14, are arranged in this order.

Herein, "transparent" indicates that visible light is transmitted, and may scatter light to some extent. In a scattering degree of light, a level to be required is different according to the application of the transparent conductor 100. In general, a semi-transparent conductor in which light is scattered, is also included in the concept of the "transparent" herein. It is preferable that the scattering degree of light is small, and it is preferable that transparency is high. The total light transmittance of the entire transparent conductor 100, for example, is greater than or equal to 84%, is preferably greater than or equal to 86%, and is more preferably greater than or equal to 88%. The total light transmittance is a transmittance including diffused and transmitted light obtained by using an integrating sphere, and is measured by using a commercially available hazemeter.

The transparent resin base material 10 is not particularly limited, and may be an organic resin film having flexibility. The organic resin film may be an organic resin sheet. Examples of the organic resin film include a polyester film such as polyethylene terephthalate (PET) and polyethylene naphthalate (PEN), a polyolefin film such as polyethylene and polypropylene, a polycarbonate film, an acrylic film, a norbornene film, a polyarylate film, a polyether sulfone film, a diacetyl cellulose film, a triacetyl cellulose film, and the like. Among them, the polyester film such as polyethylene terephthalate (PET) and polyethylene naphthalate (PEN) is preferable.

It is preferable that the transparent resin base material 10 is thick from the viewpoint of rigidity. On the other hand, it is preferable that the transparent resin base material 10 is thin from the viewpoint of thinning the transparent conductor 100. From such a viewpoint, the thickness of the transparent resin base material 10, for example, is 10 µm to 200 µm. A refractive index of the transparent resin base material, for example, is 1.50 to 1.70, from the viewpoint of producing a transparent conductor excellent in optical properties. Furthermore, herein, the refractive index is a value measured in a condition of λ = 633 nm, and a temperature of 20°C.

The transparent resin base material 10 may be subjected to at least one surface treatment selected from the group consisting of a corona discharge treatment, a glow discharge treatment, a flame treatment, an ultraviolet ray irradiation treatment, an electron ray irradiation treatment, and an ozone treatment. The transparent resin base material may be a resin film. By using the resin film, it is possible to make the transparent conductor 100 excellent in pliability. Accordingly, the transparent conductor 100 can be more preferably used in a transparent conductor for a touch panel application, a transparent electrode for an organic device such as a flexible organic EL illumination, an electromagnetic wave shield, and the like.

The first metal oxide layer 12 contains at least one of tin oxide and niobium oxide. The tin oxide, for example, is SnO₂, and the niobium oxide, for example, is Nb₂O₅. In the first metal oxide layer 12, when the tin oxide and the niobium oxide are respectively set in terms of SnO₂ and Nb₂O₅, a molar basis content of the total of SnO₂ and Nb₂O₅ with respect to the total of metal oxides contained in the first metal oxide layer 12, is greater than or equal to 45 mol%. The upper limit of the content, for example, is less than or equal to 90 mol%, from the viewpoint of maintaining bulk conductivity. In a case where the content is greater than 90 mol%, the bulk conductivity tends to decrease.

The molar basis content is a value obtained in terms of the most stably existing metal oxide with respect to a metal oxide different from the tin oxide and the niobium oxide, in the normal temperature and the normal pressure. The content of each of the following metal oxides is obtained as described above.

In a case where the first metal oxide layer 12 contains tin oxide, and when the tin oxide is set in terms of SnO₂, it is preferable that a content of SnO₂ with respect to the total of the metal oxides contained in the first metal oxide layer 12, is greater than or equal to 30 mol%. According to such a composition, it is possible to make excellent water vapor barrier properties and insolubility with respect to an etching liquid compatible at a higher level. The upper limit of the content of SnO₂, for example, is less than or equal to 80 mol%, from the viewpoint of maintaining the transmittance to be high.

In a case where the first metal oxide layer 12 contains niobium oxide, and when the niobium oxide is set in terms of Nb₂O₅, it is preferable that a content of Nb₂O₅ with respect to the total of the metal oxides, is greater than or equal to 50 mol%. According to such a composition, it is possible to make excellent water vapor barrier properties and the insolubility with respect to the etching liquid compatible at a higher level. The upper limit of the content of Nb₂O₅, for example, is less than or equal to 80 mol%, from the viewpoint of maintaining excellent alkali resistance.

The first metal oxide layer 12 may contain both of the tin oxide and the niobium oxide, or may contain a metal oxide different from the tin oxide and the niobium oxide. Examples of a different oxide include zinc oxide, indium oxide, and titanium oxide. The first metal oxide layer 12 contains at least one of the oxides described above. The zinc oxide, for example, is ZnO, and the indium oxide, for example, is In₂O₃. The titanium oxide, for example, is TiO₂.

In a case where the first metal oxide layer 12 contains at least one of the tin oxide and the niobium oxide, and at least one selected from the zinc oxide, the indium oxide, and the titanium oxide, and when five components of the tin oxide, the niobium oxide, the zinc oxide, the indium oxide, and the titanium oxide are respectively set in terms of SnO₂, Nb₂O₅, ZnO, In₂O₃, and TiO₂, the content of the total of SnO₂ and Nb₂O₅ with respect to the total of the five components, for example, is 45 mol% to 80 mol%. The content of the total of ZnO, In₂O₃, and TiO₂ with respect to the five components, for example, is 20 mol% to 55 mol%. According to such a composition, it is possible to improve alkali resistance while making excellent water vapor barrier properties and the insolubility with respect to the etching liquid compatible at a higher level. A proportion between a metal atom and an oxygen atom of each of the metal oxides contained in the first metal oxide layer 12, may deviate from a stoichiometric proportion. In addition, the first metal oxide layer 12 may contain an oxide having the same metal element and different oxidation numbers.

The first metal oxide layer 12 has both of a function of adjusting the optical properties and a function of protecting the metal layer 16. The first metal oxide layer 12 may contain a trace component or an inevitable component in addition to the metal oxides described above, in a range not considerably impairing the function. A ratio of the total of the five components to the total of the metal oxides contained in the first metal oxide layer 12, may be greater than or equal to 95 mol%, or may be greater than or equal to 97 mol%. The first metal oxide layer 12 may not contain a metal oxide other than the five components described above.

It is preferable that the first metal oxide layer 12 is transparent, and is not dissolved in an etching liquid containing a phosphoric acid, an acetic acid, a nitric acid, and a hydrofluoric acid. The etching liquid can be prepared by blending a PAN-based etching liquid containing a phosphoric acid, an acetic acid, and a nitric acid, with a hydrofluoric acid.

It is preferable that the first metal oxide layer 12 is amorphous. Accordingly, it is further improve water vapor barrier properties of the first metal oxide layer 12. The first metal oxide layer 12 can be amorphous by adjusting the composition.

The second metal oxide layer 14 is a transparent layer containing an oxide, and for example, contains four components of zinc oxide, indium oxide, titanium oxide, and tin oxide, as a main component. The second metal oxide layer 14 contains the four components described above as a main component, and thus, it is possible to produce the second metal oxide layer 14 having both of excellent conductivity and excellent transparency. The zinc oxide, for example, is ZnO, and the indium oxide, for example, is In₂O₃. The titanium oxide, for example, is TiO₂, and the tin oxide, for example, is SnO₂. A proportion between a metal atom and an oxygen atom of each of the metal oxides described above, may deviate from a stoichiometric proportion. A proportion between a metal atom and an oxygen atom of each of the metal oxides contained in the second metal oxide layer 14, may deviate from a stoichiometric proportion. In addition, the second metal oxide layer 14 may contain an oxide having the same metal element and different oxidation numbers.

In the second metal oxide layer 14, when the four components of the zinc oxide, the indium oxide, the titanium oxide, and the tin oxide, are respectively set in terms of ZnO, In₂O₃, TiO₂, and SnO₂, a content of SnO₂ with respect to the total of four components is preferably 12 mol% to 30 mol%. By setting the content of SnO₂ to be in the range described above, it is possible to make high conductivity and solubility with respect to the etching liquid compatible at a sufficiently high level. The content of SnO₂ is more preferably 15 mol% to 25 mol%.

A content of ZnO with respect to the total of the four components, is preferably 20 mol% to 50 mol%, and is more preferably 30 mol% to 50 mol%, from the viewpoint of making excellent transparency and excellent conductivity compatible. A content of In₂O₃ with respect to the total of the four components, is preferably 20 mol% to 35 mol%, and is more preferably 22 mol% to 30 mol%, from the viewpoint of making excellent transparency and high conductivity compatible. A content of TiO₂ with respect to the total of the four components, is preferably 10 mol% to 15 mol%, and is more preferably 12 mol% to 15 mol%, from the viewpoint of making high conductivity and excellent corrosion resistance compatible.

The second metal oxide layer 14 may contain metal oxide different from the metal oxide described above. For example, second metal oxide layer 14 may contain niobium oxide. However, when the tin oxide and the niobium oxide are respectively set in terms of SnO₂ and Nb₂O₅, a molar basis content of the total of SnO₂ and Nb₂O₅ with respect to the total of the metal oxides contained in the second metal oxide layer 14, may be less than the content in the first metal oxide layer, obtained as described above. That is, the molar basis content of the total of SnO₂ and Nb₂O₅ with respect to the total of the metal oxides contained in the second metal oxide layer 14, is less than 45 mol%, is preferably 12 mol% to 30 mol%, and is more preferably 15 mol% to 25 mol%. Accordingly, it is possible to make high conductivity and the solubility with respect to the etching liquid compatible at a sufficiently high level.

The second metal oxide layer 14 has all of a function of adjusting the optical properties, a function of protecting the metal layer 16, and a function of ensuring the conductivity, the solubility with respect to the etching liquid, and the alkali resistance. The second metal oxide layer 14 may contain a trace component or an inevitable component in addition to the components described above, in a range not considerably impairing the function. A ratio of the total of the four components to the total of the metal oxides contained in the second metal oxide layer 14, for example, may be greater than or equal to 95 mol%, or may be greater than or equal to 97 mol%. The second metal oxide layer 14 may not contain a metal oxide other than the four components described above.

The first metal oxide layer 12 and the second metal oxide layer 14 have compositions different from each other. Accordingly, in one step, only the second metal oxide layer 14 and the metal layer 16 are removed by etching, and thus, the first metal oxide layer 12 is capable of remaining as it is.

The thickness of the first metal oxide layer 12 and the second metal oxide layer 14, for example, is less than or equal to 80 nm, from the viewpoint of further improving the transparency. On the other hand, the thickness, for example, is less than or equal to 20 nm, from the viewpoint of further improving the corrosion resistance, and of improving productivity.

The first metal oxide layer 12 and the second metal oxide layer 14 can be produced by a vacuum film formation method such as a vacuum vapor deposition method, a sputtering method, an ion plating method, or a CVD method. Among them, the sputtering method is preferable from the viewpoint of downsizing a film formation chamber and of a high film formation rate. Examples of the sputtering method include DC magnetron sputtering. An oxide target, and a metal target or a semimetal target can be used as a target.

A wiring electrode or the like may be disposed on the second metal oxide layer 14. A current to be conducted through metal layer 16 described below, is guided from the wiring electrode or the like, disposed on the second metal oxide layer 14 to another wiring electrode or the like, disposed on the second metal oxide layer 14, through the second metal oxide layer 14. For this reason, it is preferable that the second metal oxide layer 14 has high conductivity. From such a viewpoint, a surface resistance value in a single layer of the second metal oxide layer 14, for example, is preferably less than or equal to 1.0 × 10⁺⁷ Ω/sq., and is more preferably less than or equal to 5.0 × 10⁺⁶ Ω/sq.

The metal layer 16 is a layer containing a silver alloy, as a main component. The metal layer 16 has high transparency and high conductivity, and thus, it is possible to sufficiently decrease surface resistance while sufficiently increasing the total light transmittance of the transparent conductor 100. Examples of a constituent element of the silver alloy, include Ag, and at least one type selected from Pd, Cu, Nd, In, Sn, and Sb. Examples of the silver alloy include Ag-Pd, Ag-Cu, Ag-Pd-Cu, Ag-Nd-Cu, Ag-In-Sn, and Ag-Sn-Sb.

A content of a metal other than silver, for example, is 0.5 mass% to 5 mass% on the basis of the metal layer 16, from the viewpoint of further improving the corrosion resistance and the transparency. It is preferable that the silver alloy contains Pd as the metal other than silver. Accordingly, it is possible to further improve durability in an environment of a high temperature and high humidity. A content of Pd in the silver alloy, for example, may be greater than or equal to 1 mass%. It is preferable that the silver alloy contains Cu along with Ag and Pd. Accordingly, a degradation such as the migration of the metal layer 16, is further suppressed, and the corrosion resistance of the transparent conductor 100 can be improved.

The thickness of the metal layer 16, for example, is 1 nm to 30 nm. The thickness of the metal layer 16 is preferably 4 nm to 20 nm, from the viewpoint of sufficiently increasing the total light transmittance while sufficiently decreasing a water vapor permeation rate of the transparent conductor 100. In a case where the thickness of the metal layer 16 is excessively large, the total light transmittance tends to decrease. On the other hand, in a case where the thickness of the metal layer 16 is excessively small, the total light transmittance and the corrosion resistance tend to decrease, and the surface resistance tends to increase.

The metal layer 16 has a function of adjusting the total light transmittance and the surface resistance of the transparent conductor 100. The metal layer 16 can be produced by a vacuum film formation method such as a vacuum vapor deposition method, a sputtering method, an ion plating method, or a CVD method. Among them, the sputtering method is preferable from the viewpoint of downsizing a film formation chamber and of a high film formation rate. Examples of the sputtering method include DC magnetron sputtering. An oxide target, and a metal target or a semimetal target can be used as a target.

It is preferable that the transparent conductor 100 has a low water vapor permeation rate. The water vapor permeation rate (WVTR) of the transparent conductor 100, for example, may be less than or equal to 5 × 10⁻³ g/m²/day, or may be less than or equal to 5 × 10⁻⁴ g/m²/day, in a state of being patterned. The transparent conductor 100 has a low water vapor permeation rate, and thus, water vapor can be sufficiently blocked, and therefore, in particular, the transparent conductor 100 can be preferably used as a transparent electrode of an organic device. Herein, the water vapor permeation rate (WVTR) is a value measured by using a commercially available measurement device such as a MOCON type water vapor permeation rate measurement device (AQATRAN) manufactured by Hitachi High-Technologies Corporation.

At least a part of the second metal oxide layer 14 and at least a part of the metal layer 16 in the transparent conductor 100, may be removed by etching or the like. In this case, a conductor pattern is formed by the metal layer 16 and the second metal oxide layer 14. A part of the first metal oxide layer 12 may be removed by etching or the like.

A resistance value of the transparent conductor 100, for example, is less than or equal to 30 Ω/sq. In the related art, an ITO film having a thickness of greater than or equal to 100 nm, is used as a transparent electrode, but it is difficult to sufficiently decrease resistance. The transparent conductor 100 is capable of decreasing the resistance to be less than that of ITO having the thickness described above, and is preferably used as a transparent electrode for an application in which low resistance is required. In addition, the transparent conductor 100 can be used in a liquid crystal screen and an antenna.

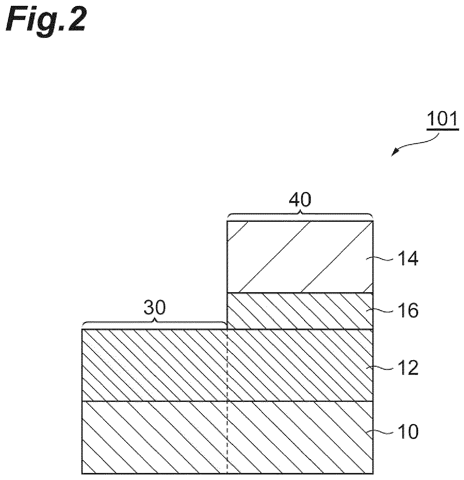

FIG. 2 is a schematic sectional view illustrating another embodiment of the transparent conductor. A transparent conductor 101 includes a conductive portion 40 (a second laminated portion) including the transparent resin base material 10, the first metal oxide layer 12, the metal layer 16, and the second metal oxide layer 14, in this order, and a non-conductive portion 30 (a first laminated portion) including the transparent resin base material 10 and the first metal oxide layer 12 but not the second metal oxide layer 14 and the metal layer 16. The conductive portion 40 and the non-conductive portion 30 are formed to be adjacent to each other.

The transparent conductor 101 is obtained by removing the second metal oxide layer 14 and the metal layer 16 of the transparent conductor 100 of FIG. 1 by etching. In the non-conductive portion 30, a front surface (one main surface) of the first metal oxide layer 12 is exposed. On the other hand, the conductive portion 40 includes the metal layer 16 and the second metal oxide layer 14 on the front surface of the first metal oxide layer 12, and configures a conductor pattern.

The transparent conductor 101 includes the first metal oxide layer 12 not only in the conductive portion 40, but also in the non-conductive portion 30. The first metal oxide layer 12 has excellent water vapor barrier properties. For this reason, the patterned transparent conductor 101 is capable of maintaining excellent water vapor barrier properties. A water vapor permeation rate (WVTR) of the transparent conductor 101, for example, may be less than or equal to 5 × 10⁻² g/m²/day, or may be less than or equal to 1 × 10⁻² g/m²/day. The transparent conductor 101 having a conductor pattern in a predetermined shape, has excellent water vapor barrier properties, and thus, can be preferably used as a transparent electrode for a transparent electrode, an antistatic transparent electrode, and an electromagnetic wave shielding transparent electrode, in an organic device such as an organic EL display, an organic EL illumination, and an organic thin film solar battery, a light control film, and various display devices such as electronic paper.

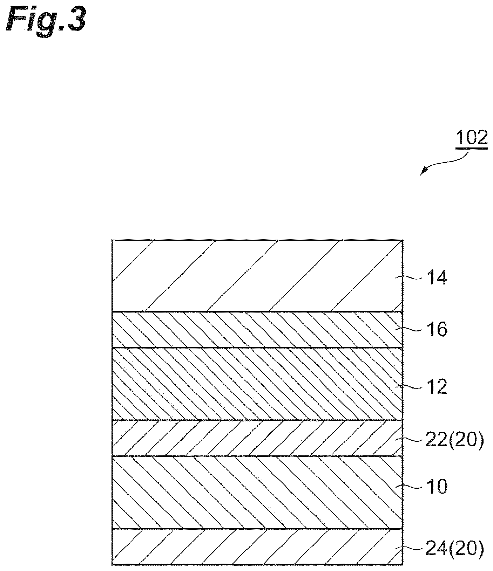

FIG. 3 is a schematic sectional view illustrating still another embodiment of the transparent conductor. A transparent conductor 102 is different from the transparent conductor 100 of FIG. 1, in that a pair of hard coat layers 20 are provided to interposing the transparent resin base material 10 therebetween. Other configurations are identical to those of the transparent conductor 100.

The transparent conductor 102 includes a first hard coat layer 22 on a main surface of the transparent resin base material 10 on the first metal oxide layer 12 side, and a second hard coat layer 24 on a main surface of the transparent resin base material 10 on a side opposite to the first metal oxide layer 12 side, as the pair of hard coat layers 20. That is, the transparent conductor 102 has a laminated structure in which the second hard coat layer 24, the transparent resin base material 10, the first hard coat layer 22, the first metal oxide layer 12, the metal layer 16, and the second metal oxide layer 14 are laminated in this order. The thicknesses, the structures, and the compositions of the first hard coat layer 22 and the second hard coat layer 24, may be identical to each other, or may be different from each other. In addition, it is not necessary to include both of the first hard coat layer 22 and the second hard coat layer 24, and any one of the first hard coat layer 22 and the second hard coat layer 24 may be provided.

By disposing the hard coat layer 20, it is possible to sufficiently suppress scratches generated on the transparent resin base material 10. The hard coat layer 20 contains a resin cured product obtained by curing a resin composition. It is preferable that the resin composition contains at least one type selected from a thermosetting resin composition, an ultraviolet ray curable resin composition, and an electron ray curable resin composition. The thermosetting resin composition may contain at least one type selected from an epoxy-based resin, a phenoxy-based resin, and a melamine-based resin.

The resin composition, for example, is a composition containing a curable compound having an energy ray reactive group such as a (meth)acryloyl group and a vinyl group. Furthermore, the notation of the (meth)acryloyl group, indicates that at least one of an acryloyl group and a methacryloyl group is included. It is preferable that the curable compound contains a multifunctional monomer or oligomer having two or more, and preferably three or more energy ray reactive groups in one molecule.

The curable compound preferably contains an acrylic monomer. Specifically, examples of the acrylic monomer include 1,6-hexanediol di(meth)acrylate, triethylene glycol di(meth)acrylate, ethylene oxide-modified bisphenol A di(meth)acrylate, trimethylol propane tri(meth)acrylate, trimethylol propane ethylene oxide-modified tri(meth)acrylate, trimethylol propane propylene oxide-modified tri(meth)acrylate, pentaerythritol tetra(meth)acrylate, ditrimethylol propane tetra(meth)acrylate, dipentaerythritol penta(meth)acrylate, dipentaerythritol hexa(meth)acrylate, pentaerythritol tri(meth)acrylate, 3-(meth)acryloyl oxyglycerin mono(meth)acrylate, and the like. However, the acrylic monomer is not necessarily limited thereto. Examples of the acrylic monomer also include urethane-modified acrylate, epoxy-modified acrylate, and the like.

A compound having a vinyl group may be used as the curable compound. Examples of the compound having a vinyl group include ethylene glycol divinyl ether, pentaerythritol divinyl ether, 1,6-hexanediol divinyl ether, trimethylol propane divinyl ether, ethylene oxide-modified hydroquinone divinyl ether, ethylene oxide-modified bisphenol A divinyl ether, pentaerythritol trivinyl ether, dipentaerythritol hexavinyl ether, ditrimethylol propane polyvinyl ether, and the like. However, the compound having a vinyl group is not necessarily limited thereto.

In a case where the curable compound is cured by an ultraviolet ray, the resin composition contains a photopolymerization initiator. Various photopolymerization initiators can be used as the photopolymerization initiator. For example, the photopolymerization initiator may be suitably selected from known compounds such as an acetophenone-based compound, a benzoin-based compound, a benzophenone-based compound, and a thioxanthone-based compound. More specifically, examples of the photopolymerization initiator include Darocur 1173, Irgacure 651, Irgacure 184, and Irgacure 907 (Product Names, manufactured by BASF SE), and KAYACURE DETX-S (Product Name, manufactured by Nippon Kayaku Co., Ltd.).

The photopolymerization initiator may be approximately 0.01 mass% to 20 mass%, or may be approximately 0.5 mass% to 5 mass%, with respect to the mass of the curable compound. The resin composition may be a known resin composition in which a photopolymerization initiator is added to an acrylic monomer. Examples of the resin composition in which the photopolymerization initiator is added to the acrylic monomer, include SD-318 (Product Name, manufactured by DIC Corporation), which is an ultraviolet ray curable resin, XNR5535 (Product Name, manufactured by Nagase Sangyo Co., Ltd.), and the like.

The resin composition may contain organic fine particles and/or inorganic fine particles, in order to increase the strength of a coated film and/or to adjust a refractive index. Examples of the organic fine particles include organic silicon fine particles, cross-linking acryl fine particles, cross-linking polystyrene fine particles, and the like. Examples of the inorganic fine particles include silicon oxide fine particles, aluminum oxide fine particles, zirconium oxide fine particles, titanium oxide fine particles, iron oxide fine particles, and the like. Among them, the silicon oxide fine particles are preferable.

Fine particles in which a front surface is treated with a silane coupling agent, and an energy ray reactive group such as a (meth)acryloyl group and/or a vinyl group, exists on the front surface in the shape of a film, are preferable as the fine particles. In a case of using such fine particles having reactivity, the fine particles react with each other, or fine particles react with a multifunctional monomer or oligomer, at the time of being irradiated with an energy ray, and thus, it is possible to increase the strength of the film. Silicon oxide fine particles treated with a silane coupling agent having a (meth)acryloyl group are preferably used.

The average particle diameter of the fine particles is less than the thickness of the hard coat layer 20, and may be less than or equal to 100 nm, or may be less than or equal to 20 nm, from the viewpoint of ensuring sufficient transparency. On the other hand, the average particle diameter may be greater than or equal to 5 nm, or may be greater than or equal to 10 nm, from the viewpoint of manufacturing a colloid solution. In a case of using the organic fine particles and/or the inorganic fine particles, the total amount of the organic fine particles and the inorganic fine particles, for example, may be 5 parts by mass to 500 parts by mass, or may be 20 parts by mass to 200 parts by mass, with respect to 100 parts by mass of the curable compound.

In a case of using the resin composition which is cured by an energy ray, the resin composition can be cured by being irradiated with an energy ray such as an ultraviolet ray. Therefore, it is preferable to use such a resin composition from the viewpoint of a manufacturing process.

The first hard coat layer 22 can be produced by applying a solution or a dispersion liquid of the resin composition onto one surface of the transparent resin base material 10, by drying the solution or the dispersion liquid, and by curing the resin composition. At this time, the coating can be performed by a known method. Examples of coating method include an extrusion nozzle method, a blade method, a knife method, a bar coat method, a kiss coat method, a kiss reverse method, a gravure roll method, a dip method, a reverse roll method, a direct roll method, a curtain method, a squeeze method, and the like. The second hard coat layer 24 can be produced on the other surface of the transparent resin base material 10, as with the first hard coat layer 22.

The thickness of the first hard coat layer 22 and the second hard coat layer 24, for example, is 0.5 µm to 10 µm. In a case where the thickness is greater than 10 µm, thickness unevenness, wrinkles, or the like tend to be easily generated. On the other hand, in a case where the thickness is less than 0.5 µm, and a low-molecular weight component such as a plasticizer or an oligomer is considerably contained in the transparent resin base material 10, there is a case where it is difficult to sufficiently suppress the bleed-out of the component. Furthermore, it is preferable that the thicknesses of the first hard coat layer 22 and the second hard coat layer 24, are approximately the same, from the viewpoint of suppressing warpage.

A refractive index of the first hard coat layer 22 and the second hard coat layer 24, for example, is 1.40 to 1.60. It is preferable that an absolute value of a difference between the refractive index of the transparent resin base material 10 and the refractive index of the first hard coat layer 22, is less than or equal to 0.1. It is preferable that an absolute value of a difference between the refractive index of the transparent resin base material 10 and the refractive index of the second hard coat layer 24, is also less than or equal to 0.1. By decreasing the absolute value of the difference between the refractive index of the first hard coat layer 22 and the second hard coat layer 24, and the refractive index of the transparent resin base material 10, it is possible to suppress the degree of interference unevenness which is generated due to unevenness in the thickness of the first hard coat layer 22 and the second hard coat layer 24.

The thickness of each layer configuring the transparent conductors 100, 101, and 102 according to each of the embodiments described above, can be measured by the following procedure. The transparent conductors 100, 101, and 102 are cut by a focused ion beam device (FIB), and thus, a sectional surface is obtained. The sectional surface is observed by using a transmission electron microscope (TEM), and the thickness of each of the layers is measured. It is preferable that the measurement is performed in 10 or more positions which are arbitrarily selected, and the average value thereof is obtained. A microtome may be used in a method of obtaining the sectional surface, as a device other than the focused ion beam device. An electron scanning microscope (SEM) may be used in a method of measuring the thickness. In addition, it is also possible to measure a film thickness by using a fluorescent X-ray device.

The thickness of the transparent conductors 100, 101, and 102 may be less than or equal to 300 µm, or may be less than or equal to 250 µm. According to such a thickness, it is possible to sufficiently satisfy the required level of thinning. The total light transmittance of the transparent conductors 100, 101, and 102, for example, can be a high value of greater than or equal to 84%.

In a case where the transparent conductors 100, 101, and 102 are used in an organic device, the transparent conductors 100, 101, and 102 are used as a positive electrode of the organic device. Then, an organic layer, a reflection electrode (a negative electrode), and a sealing film are disposed on the patterned second metal oxide layer 14, in this order from the second metal oxide layer 14 side. The organic layer is easily degraded by moisture, but it is possible to prolong the life of the organic device by using the transparent conductors 100, 101, and 102 having high water vapor barrier properties as the positive electrode. In addition, the transparent conductors 100, 101, and 102 can also be used as a negative electrode of the organic device.

As described above, some embodiments of the present invention have been described, but the present invention is not limited to the embodiments described above. For example, the transparent conductor 102 includes the pair of hard coat layers 20, but may include only one of the first hard coat layer 22 and the second hard coat layer 24. In addition, the hard coat layer is disposed on one surface of the transparent resin base material 10, and a plurality of optical adjustment layers may be disposed on the other surface by coating. In this case, the first metal oxide layer 12, the metal layer 16, and the second metal oxide layer 14 may be disposed on the optical adjustment layer. Further, in the transparent conductors 100, 101, and 102, an arbitrary layer other than the layers described above, may be disposed in an arbitrary position, in a range not considerably impairing the function.

### EXAMPLES

Hereinafter, the present invention will be more specifically described by examples and comparative examples, but the present invention is not limited to the examples.

### [Examples 1 to 5 and Comparative Examples 1 to 7]

### (Production of Transparent Conductor)

A transparent conductor as illustrated in FIG. 1, was produced. The transparent conductor has a laminated structure in which a transparent resin base material, a first metal oxide layer, a metal layer, and a second metal oxide layer are laminated in this order. Transparent conductors of each of the examples and each of the comparative examples were produced in the following manner.

A commercially available polyethylene terephthalate film (Thickness: 125 µm) was prepared. The PET film was used as the transparent resin base material. The first metal oxide layer, the metal layer, and the second metal oxide layer were sequentially formed on the PET film, by DC magnetron sputtering. The first metal oxide layer and the second metal oxide layer in each of the examples and each of the comparative examples, were formed by using a target having a composition shown in Table 1 and Table 2. For example, a target of Example 1 contained SnO₂ and ZnO at a molar ratio of 45 : 55. However, in Comparative Example 7, an AlN layer produced according to reactive sputtering of mixed gas of argon gas and nitrogen gas by using an Al target, was set to the first metal oxide layer.

The first metal oxide layer and the second metal oxide layer formed in each of the examples and each of the comparative examples, have the same composition as that of the used target, except for the first metal oxide layer of Comparative Example 7. In Table 1 and Table 2, a molar basis content of the total of SnO₂ and Nb₂O₅ with respect to the total of metal oxides contained in the first metal oxide layer and the second metal oxide layer, is also shown. The thickness of the first metal oxide layer and the second metal oxide layer in each of the examples, was 40 nm.

In all of the examples shown in Table 1, the metal layer was formed by using an Ag-Pd-Cu (Ag : Pd : Cu = 99.0 : 0.7 : 0.3 (mass%)) target. The thickness of the metal layer was 10 nm.

### (Evaluation of Transparent Conductor)

The crystallinity of the first metal oxide layer and the second metal oxide layer in the transparent conductor of each of the examples and each of the comparative examples, was evaluated by using XRD. That is, a case where a diffraction peak was observed in a range where a diffraction angle (2θ) according to an X-ray diffraction method was 20° to 60°, was determined as being crystallinity, and a case where the diffraction peak was not observed, was determined as amorphousness. For example, the first metal oxide layer and the second metal oxide layer, containing ZnO, can be determined according to the presence or absence of a diffraction peak from a (002) plane of ZnO. Even in a case where ZnO is not contained, the first metal oxide layer and the second metal oxide layer can be determined according to the presence or absence of a diffraction peak from a (002) plane of TiO₂, Nb₂O₅, or AIN. A determination result is shown in the section of crystallinity in Table 1 and Table 2. In Table 1 and Table 2, "C" represents crystallinity, and "A" represents amorphousness.

Etching properties of the transparent conductor of each of the examples and each of the comparative examples, were evaluated in the following procedure. First, a PAN-based etching liquid containing a phosphoric acid, an acetic acid, and a nitric acid, and a hydrofluoric acid were mixed, and thus, an etching liquid was prepared. The transparent conductor was dipped in the etching liquid at a room temperature for 10 minutes, and etching was performed. After that, it was determined whether or not the second metal oxide layer, the metal layer, and the first metal oxide layer were dissolved by measuring the total light transmittance.

It was confirmed whether or not the second metal oxide layer, the metal layer, and the first metal oxide layer were dissolved, by measuring the total light transmittance. The total light transmittance (the transmittance) was measured by using a hazemeter (Product Name: NDH-7000, manufactured by Nippon Denshoku Industries). In a case where the total light transmittance after the etching, was coincident with the total light transmittance of the transparent resin base material, it was determined that all of the second metal oxide layer, the metal layer, and the first metal oxide layer were dissolved. In a case where the total light transmittance after the etching, was coincident with the total light transmittance of a laminate of the first metal oxide layer and the transparent resin base material, it was determined that the second metal oxide layer and the metal layer were dissolved. In a case where the total light transmittance was not changed before and after the etching, it was determined that none of the second metal oxide layer, the metal layer, and the first metal oxide layer was dissolved.

In the section of "Solubility" in Table 1, it was represented whether or not the first metal oxide layer was dissolved. In the section of "Solubility" in Table 2, it was represented whether or not the second metal oxide layer is dissolved. In the section of "Etching properties" in Table 3, a case where the second metal oxide layer and the metal layer were dissolved, was represented as "A", and a case where all of the second metal oxide layer, the metal layer, and the first metal oxide layer were dissolved, was represented as "B". Furthermore, in the examples and the comparative examples, there was no case where none of the second metal oxide layer, the metal layer, and the first metal oxide layer was dissolved.

Water vapor barrier properties of the transparent conductor of each of the examples and each of the comparative examples were evaluated in the following procedure. A water vapor permeation rate was measured in a condition of 40°C and 90%RH, by using a MOCON type water vapor permeation rate measurement device (AQATRAN) manufactured by Hitachi High-Technologies Corporation. The measurement was performed before and after the evaluation of "Etching properties" described above. A measurement result is shown in Table 3.

**[Table 1]**

| | First metal oxide layer | | | | |
|---|---|---|---|---|---|
| | Composition | | SnO₂ + Nb₂O₅ mol% | Crystallinity | Solubility |
| | Metal oxide | Content (mol%) | | | |
| Example 1 | SnO₂-ZnO | 45-55 | 45 | A | Insoluble |
| Example 2 | SnO₂-ZnO | 75-25 | 75 | A | Insoluble |
| Example 3 | TiO₂-Nb₂O₅ | 50-50 | 50 | A | Insoluble |
| Example 4 | TiO₂-Nb₂O₅ | 20-80 | 80 | A | Insoluble |
| Example 5 | ZnO-SnO₂-Nb₂O₅ | 55-33-12 | 45 | A | Insoluble |
| Comparative Example 1 | ZnO-SnO₂-Nb₂O₅ | 78-10-12 | 24 | A | Soluble |
| Comparative Example 2 | ZnO-In₂O₃-Nb₂O₅ | 50-15-35 | 35 | A | Soluble |
| Comparative Example 3 | SnO₂-ZnO | 20-80 | 20 | A | Soluble |
| Comparative Example 4 | TiO₂-Nb₂O₅ | 75-25 | 25 | A | Soluble |
| Comparative Example 5 | ZnO-Ga₂O₃-GeO₂ | 81-9-10 | 0 | C | Soluble |
| Comparative Example 6 | Ga₂O₃-ZnO | 5-95 | 0 | C | Soluble |
| Comparative Example 7 | AIN | 100 | 0 | C | Insoluble |

**[Table 2]**

| | Second metal oxide layer | | | | |
|---|---|---|---|---|---|
| | Composition | | SnO₂ + Nb₂O₅ mol% | Crystallinity | Solubility |
| | Metal oxide | Content (mol%) | | | |
| Example 1 | ZnO-In₂O₃-TiO₂-SnO₂ | 44-26-11-19 | 19 | A | Soluble |
| Example 2 | ZnO-In₂O₃-TiO₂-SnO₂ | 44-26-11-19 | 19 | A | Soluble |
| Example 3 | ZnO-In₂O₃-TiO₂-SnO₂ | 44-26-11-19 | 19 | A | Soluble |
| Example 4 | ZnO-In₂O₃-TiO₂-SnO₂ | 44-26-11-19 | 19 | A | Soluble |
| Example 5 | ZnO-In₂O₃-TiO₂-SnO₂ | 44-26-11-19 | 19 | A | Soluble |
| Comparative Example 1 | ZnO-In₂O₃-TiO₂-SnO₂ | 44-26-11-19 | 19 | A | Soluble |
| Comparative Example 2 | ZnO-In₂O₃-TiO₂-SnO₂ | 44-26-11-19 | 19 | A | Soluble |
| Comparative Example 3 | ZnO-In₂O₃-TiO₂-SnO₂ | 44-26-11-19 | 19 | A | Soluble |
| Comparative Example 4 | ZnO-In₂O₃-TiO₂-SnO₂ | 44-26-11-19 | 19 | A | Soluble |
| Comparative Example 5 | ZnO-In₂O₃-TiO₂-SnO₂ | 44-26-11-19 | 19 | A | Soluble |
| Comparative Example 6 | ZnO-In₂O₃-TiO₂-SnO₂ | 44-26-11-19 | 19 | A | Soluble |
| Comparative Example 7 | ZnO-In₂O₃-TiO₂-SnO₂ | 44-26-11-19 | 19 | A | Soluble |

**[Table 3]**

| | Etching properties | Water vapor permeation rate (g/m²/day) | |
|---|---|---|---|
| | | Before etching | After etching |
| Example 1 | A | ≤ 5 × 10⁻⁴ | 2 × 10⁻² |
| Example 2 | A | ≤ 5 × 10⁻⁴ | 2 × 10⁻² |
| Example 3 | A | ≤ 5 × 10⁻⁴ | 2 × 10⁻² |
| Example 4 | A | ≤ 5 × 10⁻⁴ | 2 × 10⁻² |
| Example 5 | A | ≤ 5 × 10⁻⁴ | 2 × 10⁻² |
| Comparative Example 1 | B | ≤ 5 × 10⁻⁴ | 70 |
| Comparative Example 2 | B | ≤ 5 × 10⁻⁴ | 70 |
| Comparative Example 3 | B | ≤ 5 × 10⁻⁴ | 70 |
| Comparative Example 4 | B | ≤ 5 × 10⁻⁴ | 70 |
| Comparative Example 5 | B | 8 × 10⁻³ | 70 |
| Comparative Example 6 | B | 8 × 10⁻³ | 70 |
| Comparative Example 7 | A | 8 × 10⁻³ | 0.6 |

As shown in Table 3, it was confirmed that the transparent conductor of each of the examples was capable of maintaining excellent water vapor barrier properties even after the etching. In addition, it was confirmed that the transparent conductor of each of the examples was excellent in the etching properties, and thus, was capable of being easily patterned.

### Industrial Applicability

According to the present disclosure, a transparent conductor is provided in which patterning is easily performed, and excellent water vapor barrier properties can be maintained even after the patterning.

### Reference Signs List

10: transparent resin base material, 12: first metal oxide layer, 14: second metal oxide layer, 16: metal layer, 20: hard coat layer, 22: first hard coat layer, 24: second hard coat layer, 100, 101, 102: transparent conductor.

## Claims

1. A transparent conductor, comprising:
a transparent resin base material;
a first metal oxide layer;
a metal layer including a silver alloy; and
a second metal oxide layer, in this order,
wherein the first metal oxide layer contains at least one of tin oxide and niobium oxide, and
when the tin oxide and the niobium oxide are respectively set in terms of SnO₂ and Nb₂O₅,
a molar basis content of the total of SnO₂ and Nb₂O₅ with respect to the total of metal oxides contained in the first metal oxide layer, is greater than a molar basis content of the total of SnO₂ and Nb₂O₅ with respect to the total of metal oxides contained in the second metal oxide layer, and
the content in the first metal oxide layer is greater than or equal to 45 mol%.

2. The transparent conductor according to claim 1,
wherein the first metal oxide layer is not dissolved in an etching liquid containing a phosphoric acid, an acetic acid, a nitric acid, and a hydrofluoric acid, in which the second metal oxide layer is dissolved.

3. The transparent conductor according to claim 1 or 2,
wherein the first metal oxide layer contains tin oxide, and when the tin oxide is set in terms of SnO₂, a content of SnO₂ with respect to the total of the metal oxides, is greater than or equal to 30 mol%.

4. The transparent conductor according to any one of claims 1 to 3,
wherein the first metal oxide layer contains niobium oxide, and when the niobium oxide is set in terms of Nb₂O₅, a content of Nb₂O₅ with respect to the total of the metal oxides, is greater than or equal to 50 mol%.

5. The transparent conductor according to any one of claims 1 to 4,
wherein the first metal oxide layer is amorphous.

6. The transparent conductor according to any one of claims 1 to 5,
wherein the first metal oxide layer contains at least one of zinc oxide, indium oxide, and titanium oxide.

7. The transparent conductor according to any one of claims 1 to 6,
wherein the second metal oxide layer contains zinc oxide, indium oxide, titanium oxide, and tin oxide, and when four components of the zinc oxide, the indium oxide, the titanium oxide, and the tin oxide are respectively set in terms of ZnO, In₂O₃, TiO₂, and SnO₂, a content of ZnO is 20 mol% to 50 mol%, a content of In₂O₃ is 20 mol% to 35 mol%, a content of TiO₂ is 10 mol% to 15 mol%, and a content of SnO₂ is 12 mol% to 30 mol%, with respect to the total of the four components.

8. The transparent conductor according to any one of claims 1 to 7,
wherein the silver alloy includes Ag, Pd, and Cu, as a constituent element.

9. The transparent conductor according to any one of claims 1 to 8,
wherein the transparent conductor is patterned such that a part of the first metal oxide layer is exposed, and
the transparent conductor further comprises:
a first laminated portion including the transparent resin base material and the first metal oxide layer, in which the first metal oxide layer is exposed; and
a second laminated portion including the transparent resin base material, the first metal oxide layer, the metal layer, and the second metal oxide layer.
